# EUROPÄISCHE PATENTSCHRIFT

(11) **EP 1 301 949 B1**
(45) Veröffentlichungstag und Bekanntmachung des Hinweises auf die Patenterteilung: **09.01.2008**
(21) Anmeldenummer: 01967197.3
(22) Anmeldetag: 17.07.2001
(51) Int. Cl.: H01L 37/02, H01L 41/24, H03H 3/02

(54) **VERFAHREN ZUR HERSTELLUNG EINES HALBLEITERBAUELEMENTS MIT EINER PIEZO- ODER PYROELEKTRISCHEN SCHICHT**
METHOD FOR PRODUCING A SEMICONDUCTOR COMPONENT WITH A SEQUENCE OF LAYERS, FOR CONVERTING ACOUSTIC OR THERMAL SIGNALS INTO ELECTRICAL VOLTAGE CHANGES AND VICE VERSA
PROCEDE DE PRODUCTION D'UN ELEMENT SEMICONDUCTEUR COMPRENANT UNE SUCCESSION DE COUCHES ET DESTINE A LA CONVERSION DE SIGNAUX ACOUSTIQUES OU THERMIQUES EN MODIFICATIONS DE TENSION ELECTRIQUE ET VICE-VERSA

(30) Priorität: 20.07.2000 DE 10035421
(43) Veröffentlichungstag der Anmeldung: 16.04.2003
(73) Patentinhaber: Infineon Technologies AG, 81669 München (DE)
(72) Erfinder: AIGNER, Robert, 81675 München (DE); ELBRECHT, Lueder, 80805 Muenchen (DE); HERZOG, Thomas, Rainer, 85635 Hoehenkirchen-Siegertsbrunn (DE); MARKSTEINER, Stephan, 85579 Neubiberg (DE); NESSLER, Winfried, 81739 München (DE)
(74) Vertreter: Ginzel, Christian
(86) Internationale Anmeldenummer: PCT/EP2001/008248
(87) Internationale Veröffentlichungsnummer: WO 2002/009202

(56) Entgegenhaltungen:
- EP-A- 0 963 040
- EP-A- 1 124 269
- LUTSKY J J ET AL: "A sealed cavity TFR process for RF bandpass filters" 1996 INTERNATIONAL ELECTRON DEVICES MEETING, SAN FRANCISCO, CA, USA, 8. - 11. Dezember 1996, Seiten 95-98, XP000753738 ISBN: 0-7803-3394-2

## Beschreibung

Die Erfindung betrifft ein Verfahren zur Herstellung eines Halbleiterbauelements mit einer Schichtenfolge zum ineinander Umwandeln von akustischen oder thermischen Schwingungen und elektrischen Spannungsänderungen.

Ein solches Halbleiterbauelement weist typischerweise eine untere Elektrode, eine obere Elektrode und eine dazwischen angeordnete Schicht auf, die für den Fall, daß akustische Signale erzeugt oder nachgewiesen werden, piezoelektrisch ist, und für den Fall, daß thermische Schwingungen erzeugt oder nachgewiesen werden, pyroelektrisch ist. In beiden Fällen wird eine ausgeprägte Textur der Kristallstruktur der Schicht angestrebt, um einen möglichst hohen piezoelektrischen bzw. pyroelektrischen Koppelkoeffizienten zu erzielen. Je größer dieser Koppelkoeffizient ist, um so ausgeprägter sind die meßbaren elektrischen Spannungsänderungen bei einem vorgegebenen akustischen bzw. thermischen Signal.

Ein Halbleiterbauelement, bei dem durch Anlegen elektrischer Spannungsänderung akustische Schwingungen durch den piezoelektrischen Effekt erzeugt werden, ist z.B. in Dubois et al, "Properties of aluminum nitride thin films for piezoelectric transducers and microwave filter applications", Appl. Phys. Lett. Vol. 74, No.20, S.3032-3034 beschrieben. Eine Schichtenfolge, durch die die akustischen Schwingungen erzeugt werden, besteht aus einer unteren und oberen Elektrode und einer dazwischen angeordneten piezoelektrischen Schicht aus AlN. Zur Verbesserung der Textur wird vorgeschlagen, die untere Elektrode aus Platin zu erzeugen. Durch Aufwachsen der piezoelektrischen Schicht auf Platin wird eine bessere Textur der Schicht erzielt, da Platin und AlN ähnliche Kristalleigenschaften aufweisen.

Ein Verfahren zur Herstellung eines Halbleiterbauelements gemäß Oberbegriff des Anspruchs 1 ist aus EP 1 124 269 bekannt.

Der Erfindung liegt die Aufgabe zugrunde, ein Verfahren zur Herstellung eines Halbleiterbauelement mit einer Schichtenfolge zum ineinander Umwandeln von akustischen oder thermischen Signalen und elektrischen Spannungsänderungen anzugeben, deren piezoelektrische oder pyroelektrische Schicht im Vergleich zum Stand der Technik eine verbesserte Textur aufweist.

Diese Aufgabe wird gelöst durch ein Verfahren zur Herstellung eines Halbleiterbauelements mit einer Schichtenfolge zum ineinander Umwandeln von akustischen oder thermischen Signalen und elektrischen Spannungsänderungen, bei dem als Teile der Schichtenfolge mindestens eine untere Elektrode, darüber eine Schicht, die piezoelektrisch oder pyroelektrisch ist, und darüber eine obere Elektrode erzeugt werden, wobei die untere Elektrode erzeugt wird, indem ein leitendes Material abgeschieden und anschließend zum Glätten von Oberflächenrauheiten chemisch-mechanisch poliert wird.

Der Erfindung liegt die Erkenntnis zugrunde, daß die Rauheit der Oberfläche, über der die Schicht abgeschieden wird, die Qualität der Textur der Schicht wesentlich beeinflußt. Das Kristallwachstum erfolgt lokal senkrecht zur Oberfläche. Auf rauhen Oberflächen wachsen Kristallite zunächst mit großen Richtungsschwankungen, bis sie sich gegenseitig im Wachstum blockieren, und nur die im wesentlichen senkrecht gerichteten Kristallite weiterhin wachstumsfähig bleiben. Die Dicke des Teils der Schicht, in dem dieser Selektionsprozeß erfolgt, ist stark von der Rauheit der Oberfläche abhängig. Da dieser Anteil der Schicht schlechte piezo- bzw. pyroelektrische Eigenschaften aufweist, verschlechtert sich der Koppelkoeffizient der Schicht auf einer rauhen Oberfläche deutlich. Durch Glätten von Oberflächenrauheiten der unteren Elektrode wird eine besonders gute Textur der Schicht erzielt.

Bisher wurde chemisch-mechanisches Polieren (CMP) nur zum Einebnen einer Schicht, die aufgrund einer durch Vertiefungen und Gräben strukturierten Unterlage in verschiedenen Bereichen unterschiedliche Höhen aufweist, verwendet. Zu diesem Zweck wird die Dicke der abgeschiedenen Schicht um bis zu 2 µm reduziert. Erfindungsgemäß wird das chemisch-mechanische Polieren erstmals zum Glätten einer Schicht, die auf einer im wesentlichen ebenen Unterlage abgeschieden wird und lediglich aufgrund des Kristallwachstums eine gewisse Oberflächenrauheit aufweist, verwendet.

Vorzugsweise wird die Dicke des abgeschiedenen leitenden Materials durch das chemisch-mechanische Polieren um 10 bis 100 nm reduziert.

Es hat sich gezeigt, daß die Textur der Schicht besonders stark durch das Vorsehen des CMP-Schritts verbessert wird, wenn die untere Elektrode erzeugt wird, indem Wolfram durch ein CVD-Verfahren abgeschieden wird.

Zur weiteren Verbesserung der Textur der Schicht ist es vorteilhaft, auf der unteren Elektrode zunächst eine Hilfsschicht und darüber die Schicht zu erzeugen, wobei die Hilfsschicht derart erzeugt wird, daß sie ein homogen orientiertes Aufwachsen der Schicht fördert.

Besteht die Schicht aus AlN, so kann die Hilfsschicht beispielsweise aus Titan, Platin oder Ruthenium bestehen. Durch eine solche Hilfsschicht wird die Textur der Schicht verbessert, da diese Materialien ähnliche Kristalleigenschaften aufweisen wie AlN.

Eine besonders starke Verbesserung der Textur der Schicht wird erzielt, wenn die Hilfsschicht im wesentlichen aus amorphem Silizium, amorphem Siliziumoxid oder amorphem Siliziumnitrid besteht. Eine solche Hilfsschicht weist eine chemisch streng definierte Oberfläche auf, an der sich die Kristallite der Schicht beim Abscheiden in definierter Polarisation anlagern. Da amorphes Silizium eine geringe elektrische Leitfähigkeit aufweist, ist es nicht erforderlich, die Hilfsschicht zu strukturieren. Die Hilfsschicht kann als ganzflächige Schicht auf einer Halbleiterscheibe verbleiben, ohne daß die Elektroden kurzgeschlossen werden. Ferner wirkt eine Hilfsschicht aus amorphem Silizium als Diffusionsbarriere für Verunreinigungen, die aus Schichten unterhalb der unteren Elektrode während der Abscheidung der Schicht herausdiffundieren und in die Schicht eingebaut werden können. Diese Eigenschaft ist besonders vorteilhaft, da es sich gezeigt hat, daß bereits kleinste Verunreinigungen durch Sauerstoff oder Wasserstoff das Wachstum der Schicht empfindlich stören.

Die obere und/oder die untere Elektrode können im wesentlichen oder teilweise aus Wolfram, Molybdän, Platin, einer Aluminiumlegierung oder einer Kombination aus diesen Metallen bestehen.

Das Halbleiterbauelement kann als Bulk-Acoustic-Wave Resonator oder als Filter mit einem solchen Resonator erzeugt werden, wobei die Schichtenfolge auf einem Träger erzeugt wird, der so erzeugt wird, daß er durch die Schichtenfolge erzeugte akustische Schwingungen reflektiert. Dazu weist der Träger beispielsweise eine Anzahl übereinander angeordneter Schichten auf, die alternierend eine hohe und eine niedrige akustische Impedanz aufweisen.

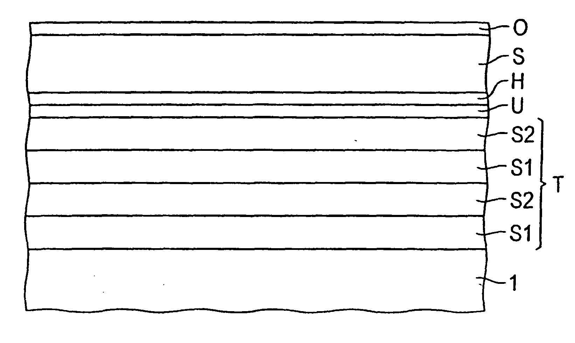

Im folgenden wird ein Ausführungsbeispiel der Erfindung anhand der Figur näher erläutert.

Die Figur zeigt einen Querschnitt durch einen Bulk-Acoustic-Wave-Resonator mit einer Schichtenfolge bestehend aus einer unteren Elektrode, einer Hilfsschicht, einer Schicht und einer oberen Elektrode und aus einem Träger.

Im Ausführungsbeispiel wird ausgehend von einem Substrat 1 aus Silizium ein Träger T erzeugt, indem eine Folge von Schichten S1, S2 abgeschieden wird, die abwechselnd eine hohe akustische Impedanz und eine niedrige akustische Impedanz aufweisen. Die Schichten S1 mit der hohen akustischen Impedanz bestehen aus Wolfram und sind ca. 850nm dick. Die Schichten S2 mit der niedrigen akustischen Impedanz bestehen aus SiO₂ und sind ca. 750nm dick.

Auf dem Träger T wird eine Schichtenfolge erzeugt. Dazu wird zunächst zur Bildung einer unteren Elektrode U Wolfram in einer Dicke von ca. 400nm abgeschieden. Anschließend wird die untere Elektrode U durch chemisch-mechanisches Polieren geglättet, wobei Wolfram bis zu einer Dicke von ca. 60nm abgetragen wird. Auf der unteren Elektrode U wird eine ca. 20nm dicke Hilfsschicht H erzeugt, indem amorphes Silizium gesputtert wird. Ohne das Substrat 1 zu belüften, wird anschließend eine piezoelektrische Schicht S erzeugt, indem AlN in einer Dicke von ca. 2µm abgeschieden wird. Darüber wird zur Erzeugung einer oberen Elektrode O Aluminium in einer Dicke von ca. 400nm abgeschieden.

Das erzeugte Bauelement ist ein Bulk-Acoustic-Wave-Resonator. Der Träger T wirkt als Bragg-Reflektor, der akustische Wellen, die durch die Schichtenfolge erzeugt werden, reflektiert. Die Dicken der Schichten S1, S2 sind so ausgelegt, daß sie bei der Betriebsfrequenz des Bulk-Acoustic-Wave-Resonators ¼ der akustischen Wellenlänge im jeweiligen Material entsprechen.

### Bezugszeichenliste

- 1: Substrat
- H: Hilfsschicht
- O,U: Elektrode
- S: Schicht
- S1, S2: Schichten des Trägers
- T: Träger

## Patentansprüche

1. Verfahren zur Herstellung eines Halbleiterbauelements mit einer Schichtenfolge zum ineinander Umwandeln von akustischen oder thermischen Signalen und elektrischen Spannungsänderungen,
bei dem als Teile der Schichtenfolge mindestens eine untere Elektrode (U), darüber eine Schicht (S), die piezoelektrisch oder pyroelektrisch ist, und darüber eine obere Elektrode (O) erzeugt werden,
**dadurch gekennzeichnet, daß**
die untere Elektrode (U) erzeugt wird, indem ein leitendes Material abgeschieden und anschließend zum Glätten von Oberflächenrauheiten chemisch-mechanisch poliert wird.

2. Verfahren nach Anspruch 1,
bei dem zur Erzeugung der unteren Elektrode (U) Wolfram durch ein CVD-Verfahren abgeschieden wird.

3. Verfahren nach Anspruch 1 oder 2,
bei dem durch das chemisch-mechanische Polieren die Dicke des abgeschiedenen leitenden Materials um 10nm bis 100nm reduziert wird.

4. Verfahren nach einem der Ansprüche 1 bis 3,
bei dem auf der unteren Elektrode (U) zunächst eine Hilfsschicht (H) und darüber die Schicht (S) erzeugt wird, wobei die Hilfsschicht (H) derart erzeugt wird, daß sie ein homogen orientiertes Aufwachsen der Schicht (S) fördert.

5. Verfahren nach Anspruch 4,
bei dem die Hilfsschicht (H) im wesentlichen aus amorphem Siliziumnitrid erzeugt wird.

6. Verfahren nach einem der Ansprüche 1 bis 5,
bei dem das Halbleiterbauelement als Bulk-Acoustic-Wave Resonator oder als Filter erzeugt wird, wobei die Schichtenfolge auf einem Träger (T) erzeugt wird, der so erzeugt wird, daß er durch die Schichtenfolge erzeugte akustische Schwingungen reflektiert.

7. Verfahren nach Anspruch 1 oder 3,
bei dem auf der unteren Elektrode (U) zunächst eine Hilfsschicht (H) und darüber die Schicht (S) erzeugt wird, wobei die Hilfsschicht (H) derart erzeugt wird, daß sie ein homogen orientiertes Aufwachsen der Schicht (S) fördert, und
bei dem die Hilfsschicht (H) im wesentlichen aus amorphem Silizium oder amorphem Siliziumoxid erzeugt wird.

## Claims

1. Process for producing a semiconductor component having a layer sequence for conversion of acoustic or thermal signals and electrical voltage changes for one another
in which a lower electrode (U), a layer (S) above it which is piezoelectrical or pyroelectrical, and an upper electrode (0) above the layer (S) are produced as parts of the layer sequence,
**characterized in that**,
the lower electrode (U) is produced by depositing a conductive material and then polishing it by chemical-mechanical means to smooth surface roughnesses.

2. Process according to Claim 1,
in which tungsten is deposited by means of a CVD process in order to produce the lower electrode (U).

3. Process according to Claim 1 or 2,
in which the thickness of the deposited conductive material is reduced by 10 nm to 100 nm by chemical-mechanical polishing.

4. Process according to one of Claims 1 to 3,
in which an auxiliary layer (H) is first of all produced on the lower electrode (U), with the layer (S) above it, with the auxiliary layer (H) being produced such that it promotes homogeneously oriented growth of the layer (S).

5. Process according to Claim 4,
in which the auxiliary layer (H) is produced essentially from amorphous silicon nitride.

6. Process according to one of Claims 1 to 5,
in which the semiconductor component is produced as a bulk acoustic wave resonator or as a filter, in which the layer sequence is arranged on a mount (T) which is produced such that it reflects acoustic oscillations produced by the layer sequence.

7. Process according to Claim 1 or 3,
in which an auxiliary layer (H) is first of all produced on the lower electrode (U), with the layer (S) above it, with the auxiliary layer (H) being produced such that it promotes homogeneously oriented growth of the layer (S), and
in which the auxiliary layer (H) is produced essentially from amorphous silicon or amorphous silicon oxide

## Revendications

1. Procédé de production d'un composant à semiconducteurs ayant une succession de couches pour transformer les uns dans les autres des signaux acoustiques ou thermiques et des variations de tension électrique,
dans lequel on produit, comme partie de la succession de couches, au moins une électrode (U) inférieure, au-dessus une couche (S) qui est piézoélectrique ou pyroélectrique et au-dessus une électrode (O) supérieure,
**caractérisé en ce que**
on produit l'électrode (U) inférieure en déposant un matériau conducteur et en polissant ensuite chémiomécaniquement pour lisser des rugosités de surface.

2. Procédé suivant la revendication 1,
dans lequel on dépose, pour la production de l'électrode (U) inférieure, du tungstène par un procédé CVD.

3. Procédé suivant la revendication 1 ou 2,
dans lequel on réduit de 10 nm à 100 nm par polissage chémiomécanique l'épaisseur du matériau conducteur déposé.

4. Procédé suivant l'une des revendications 1 à 3,
dans lequel on produit sur l'électrode (U) inférieure d'abord une couche (H) auxiliaire et dessus la couche (S) en produisant la couche (H) auxiliaire de manière à ce qu'elle favorise une croissance orientée de manière homogène de la couche (S).

5. Procédé suivant la revendication 4,
dans lequel on produit la couche (H) auxiliaire essentiellement en nitrure de silicium amorphe.

6. Procédé suivant l'une des revendications 1 à 5, dans lequel le composant à semiconducteurs est produit sous la forme d'un Bulk-Acoustic-Wave Resonator ou d'un filtre, la succession de couches étant produite sur un support (T) qui est produit de manière à réfléchir les oscillations acoustiques produites par la succession de couches.

7. Procédé suivant l'une des revendications 1 ou 3,
dans lequel on produit sur l'électrode (U) inférieure d'abord une couche (H) auxiliaire et dessus la couche (S) en produisant la couche (H) auxiliaire de manière à ce qu'elle favorise une croissance orientée de manière homogène de la couche (S), et
dans lequel on produit la couche (H) auxiliaire essentiellement en silicium amorphe ou en oxide de silicium amorphe.
